# EUROPEAN PATENT SPECIFICATION

(11) **EP 1 010 109 B1**
(45) Date of publication and mention of the grant of the patent: **07.05.2003**
(21) Application number: 97926300.1
(22) Date of filing: 20.03.1997
(51) Int. Cl.: G06F 17/50

(54) **A METHOD FOR STORING OF LAYOUT DATA, ROUTING METHOD AND ELECTRONIC DEVICE**
EIN VERFAHREN ZUM SPEICHERN VON LAYOUT-DATEN, ROUTINGVERFAHREN UND ELEKTRONISCHE VORRICHTUNG
PROCEDE DE STOCKAGE DE DONNEES D'AGENCEMENT, METHODE D'ACHEMINEMENT, ET DISPOSITIF ELECTRONIQUE

(43) Date of publication of application: 21.06.2000
(73) Proprietor: MOTOROLA, INC., Schaumburg, IL 60196 (US)
(72) Inventor: MARCHENKO, Alexander M., Moscow, 105094 (RU); BEREZIN, Evgeny G., Moscow, 107061 (RU); SHIRO, Evgeny G., Moscow, 103460 (RU); PLEKHANOV, Andrei S., Moscow, 125252 (RU); ROZENFELD, Vladimir P., Moscow, 103536 (RU); McGUINESS, Patrick, Austin, TX 78735 (US)
(74) Representative: Gibson, Sarah Jane
(86) International application number: RU9700074
(87) International publication number: WO98041938

(56) References cited:
- EP-A- 0 261 816
- EP-A- 0 646 884
- WO-A-91/06061
- FACANHA H S: "DATA STRUCTURES FOR PHYSICAL REPRESENTATION OF VLSI" SOFTWARE ENGINEERING JOURNAL, vol. 5, no. 6, 1 November 1990, pages 339-349, XP000294536

## Description

### Field of the Invention

This invention relates generally to the field of the design and fabrication of electronic devices, and more particularly to methods for storing of layout data and routing of electronic devices.

### Background of the Invention

The common approach to route a layout is the interactive graphics procedure whereby the designer creates a specific layout and uses a computer to store and, in some cases, verify the entry. The layout is actually created by the designer with record-keeping assistance from the computer. Design in the interactive mode requires the user to spend considerable amounts of time creating and describing the routing solution to the computer.

An automatic layout system, in comparison to an interactive layout system, can be defined as one which accepts input data in the form of a network list, layout element description, and program options from the user and automatically and independently routes module interconnections to produce an output containing all necessary instructions to fabricate the corresponding electronic circuit. Typically the layout is produced solely from the computer program operation on the input layout data without user intervention.

The so-called Lee path connection approach is probably the most widely used method for finding wire paths on printed circuit boards or integrated circuit chips (C. Y. Lee, "An algorithm for path connections and its applications," IRE Trans. Electron. Comput., vol. EC-10, pp. 346-365 Sept. 1961). The method devised by Lee does often form the basis for automatic layout systems. From IEEE Transactions on Computers, vol. C-23, no. 9, September 1974, "The Lee path connection algorithm", Frank Rubin an enhanced Lee path method is known in which computed cell masses are stored in order to reduce the amount of calculation for each iteration. Still the amount of computing power required in order to route complex circuit trees is very extensive.

The original Lee method is restricted to finding paths in rectangular grids and does not encompass the routing of variable width nets. Variable width routers are known for example from K. Sato et al, "A 'grid-free' channel router", in Proc. 17th design automation conf., pp. 22-31, 1980; D. W. Hightower, "A generalized channel router," in Proc. 17th Design Automation Conf., pp. 12-21, 1980; H.-J. Rothermel and D.A. Mlynski, "IC routing with variable wire width," in Proc. Eur. Conf. on Electronic Design Automation, pp. 90-94, 1981. For an overview of automatic routing techniques with real geometries reference is made to IEEE Transactions on computer-aided design, vol. cad-2, no. 4, October 1983, "Automatic variable-width routing for VLSI", Hans Jürgen Rothermel and Dieter A. Mlynski, Senior Member, IEEE.

Irrespective of the layout system, be it an interactive layout system or an automatic layout system or a mixture of both, the corresponding layout data for the electronic device have to be stored to form the basis for the manufacturing of the electronic device and/or the routing. Therefore the invention is aimed at providing an improved method for storing of layout data, an improved method for routing and manufacturing an electronic device as well as an improved electronic device being designed and fabricated in accordance with the improved method.

In the European patent application EP0646884 a method for restructuring information stored in physical design image form into a hierarchical area specification model is disclosed. The image form may be an image of a layer in a semiconductor package. It is possible to adjust the parameters that control the method to obtain a hierarchical model that is particularly suited to the requirements of a particular application program.

European patent application EP0261816 discloses a routing method applicable to the interconnections of a printed circuit board in which the circuit board is divided into a grid of addressable cells. The routing method uses board data that define e.g. number of board layers, the grid size, and the technology. The routing method uses also element data, such as shape, size and position of elements, signals and sumnets of these elements.

Routing system and method is disclosed in International Patent Application WO91/06061. This method involves a routing tree that uses tree data structure.

The data structure has set of nodes that are coupled to one another. Each node represents one channel in a circuit layout.

A bit-mapped storage technique with virtual grids and tree-based technique is disclosed in an article "Data Structures for Physical Representation of VLSI" published in Software Engineering Journal vol. 5, no. 6, 1 Nov 1990. By using the tree technique described therein it is possible to save computation time and memory.

### Summary of the Invention

The underlying problem of the invention is solved basically by applying the features laid down in the independent claims. Preferred embodiments are given in the dependent claims.

The invention is advantageous in that it provides an effective method for storing layout data which allows faster operation of a layout system relying on the improved method for storing of layout data of the invention. This is made possible by the combination of a virtual grid and a connection graph. Cells which are covered by a layout element are indexed so that a reference is made to the corresponding node in the connection graph. Thereby every routing action which is performed on the virtual grid is immediately reflected in the connection graph. As a consequence, the entire data structure comprising the virtual grid and the connection graph is guaranteed to be consistent regardless of changes in the layout. Hence the actual physical location of a net is unambiguously determined by a set of cells which are occupied by the net, and can be retrieved rapidly.

This is particularly advantageous in the case of variable net width since the pitch of the virtual grid does not have to match the maximal net width and spacing requirements. As a result, nets of different physical width can be stored by means of the same virtual grid without a need for marker specifications of net direction and branches.

According to a preferred embodiment attribute data are stored for the nodes of the connection graph such as structure type specifications, physical size and position of the corresponding layout element in the routing area, its virtual size and position in the virtual grid as well as some global net attribute, for example the net number, net physical width and spacing constrains. This attribute data typically are accessible by the reference provided by the index of the corresponding node or from the virtual grid cells by the same index. One possible implementation is to use a pointer as an indix of a layout element. In this case the pointer serves as a memory reference to a specific node of the connection graph node structure. This can be readily implemented in a programming language such as C or C++.

Further, the invention is also applicable in environments which allow to fabricate two or more layout layers. In such a case the data structure for storing of layout data is expanded to comprise an additional virtual grid for each additional layout layer. In this case the connection graph not only contains information about the interconnection of layout elements in the same virtual grid but also interconnections between layout elements being situated on different virtual grids.

The data structure which results from the storage of the layout data according to the invention can interface to any type of layout system or routing method. Many routing methods - which are as such known from the prior art - can extract information about physical layout from the data structure and transform the information contained therein to some external representation format, if needed. The combination of known routing methods with the data structure of the invention results in an improved method for routing since the overall operational speed of the computer carrying out the routing program will be increased due to easier and more efficient access to the required layout data. This also allows to reduce the cycle times required for the design and fabrication of electronic devices.

A further advantage of the method of the invention is that it also impacts the quality of the resulting design and the degree of its optimization. The data structure allows to use computing power more efficiently so that more iterations can be carried out in a given span of time. Also since data consistency is always guaranteed in the storage structure of the invention, the resulting design is error free. Therefore an electronic device which is manufactured based on this design features advantageous properties such as minimized power dissipation and enhanced operational speed due to the optimized design.

A computer program for carrying out the method for storing of layout data can be stored on a program storage device such as a magnetic disc, tape or CD-ROM so that any kind of compatible computer can be used to execute the methods of the invention under control of that program.

### Brief Description of the Drawing

FIG. 1 shows a layout area of an electronic device;
FIG. 2 shows a virtual grid corresponding to the layout area;
FIG. 3 shows a connection graph for the layout area;
FIG. 4 shows the layout area of FIG. 1 after completion of a route;
FIG. 5 shows the virtual grid of FIG. 2 and how the completion of the route is reflected in it;
FIG. 6 shows the connection graph of FIG. 3 reflecting the completed route;
FIG. 7 shows an layout area in a multi layer environment;
FIG. 8 shows the connection graph corresponding to the layout area of FIG. 7; and
FIG. 9 shows a flow diagram to illustrate one embodiment of the method of the invention.

### Detailed Description of a Preferred Embodiment

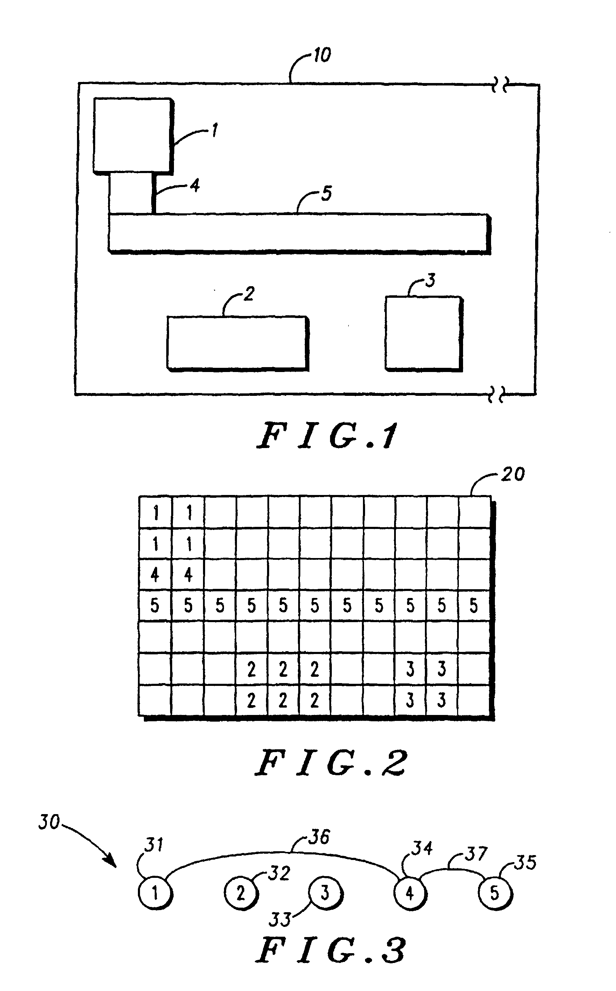

With reference to FIG. 1 to 6 a first embodiment of the invention will be described in the following: electronic device 10 of FIG. 1 can be any type of electronic device having a layout to be routed, such as a printed circuit board or VLSI circuit chip. For simplicity only a very small number of layout elements of the electronic device 10 is shown in FIG. 1. Electronic device 10 has pin 1 and pin 3. The pins 1 and 3 belong to the same net and are to be interconnected by a route. This route is not yet completed but only consists of layout elements 4 and 5. Layout element 4 is contacting pin 1 and layout element 5 is contacting layout element 4 so that the electrical connection between pins 1 and 3 is not yet completed.

As a further layout element, the electronic device 10 has an obstacle 2 which is not connected to any of the other layout elements shown in FIG. 1. The obstacle 2 can be for example a pin or layout element belonging to another net. In order to maintain signal integrity and to prevent short circuits between different nets, an electrical contact between the obstacle 2 and any of the layout elements belonging to the net of pins 1 and 3 should be avoided.

For the completion of the route interconnecting the pins 1 and 3 any routing algorithm can be employed. The problem is that such a routing algorithm has to access the physical layout information in order to trace the required layout elements within electronic device 10. In order to carry out such a routing algorithm effectively by means of a computer, the layout data has to be stored in an effective way so that the required data are easily available and accessible for the routing program.

In order to accomplish such an effective storage of the layout data first a virtual grid 20 shown in Fig. 2 is stored by means of a computer on an appropriate storage medium, such as the computer RAM or on a disc. The virtual grid 20 spans the layout area of electronic device 10 shown in FIG. 1. Each cell within the virtual grid 20 unambiguously represents the corresponding layout area of electronic device 10 which it covers. Each cell of the virtual grid 20 which covers a layout element or a portion of a layout element of the layout area shown in FIG. 1 carries an index whereas cells which do not cover a layout element but only an empty portion of the layout are also empty and do not carry an index.

In order to assign the indices to the cells in the virtual grid 20 first the layout elements of FIG. 1 are indexed. Each layout element has to be assigned an unambiguous index which serves as an unique identifier. For simplicity the reference numerals assigned to the layout elements of FIG. 1 will serve as indices in the following. For more complicated layouts than that of FIG. 1 more sophisticated index structures like tree structures will be more appropriate. Also, memory references to graph node data can serve as indices.

As a consequence the pin 1, obstacle 2, pin 3, layout element 4 and layout element 5 have the unambiguous indices 1, 2, 3, 4 and 5, respectively. These indices are also assigned to the corresponding cells in the virtual grid 20. The four cells which carry the index "1" of the grid 20 represent the corresponding physical layout area which is covered by the pin 1 in the electronic device 10 of FIG. 1. Likewise the six cells which carry the index "2" represent the layout area of obstacle 2, the four cells carrying the index "3" represent pin 3, the two cells carrying the index "4" represent the layout element 4 and the eleven cells carrying the index "5" represent the layout element 5. All the other cells of the virtual grid 20 are left empty. By indexing the layout elements and assigning the corresponding indices to cells the virtual grid 20 models the layout geometry of the layout area shown in FIG. 1.

Apart from the layout geometry the further information which is typically required by a routing program are the interconnections between the layout elements.

FIG. 3 shows a connection graph 30 which is a storage structure carrying connection information. The connection graph 30 comprises a dedicated node for each of the layout elements. An edge between two different nodes represents that the corresponding layout elements are contacting each other.

In the case considered here this results in 5 nodes 31, 32, 33, 34 and 35 which represent the layout elements 1, 2, 3, 4 and 5, respectively. Each of the nodes of the graph 30 has assigned the index of its layout element. For example the node 31 is representative of pin 1. The index which is assigned to the pin 1 is the index "1" in the example considered here so that the same index is also assigned to the node 31. The same applies analogously to the other nodes of the graph 30. As the pin 1 and the layout element 4 are contacting layout elements this is represented in the graph 30 by edge 36 between the nodes 31 and 34. Likewise edge 37 between the nodes 34 and 35 represents the fact that the layout elements 4 and 5 are contacting each other. Since no further direct electrical contacts are present in the layout of the electronic device 10, no further edges are comprised in the graph 30.

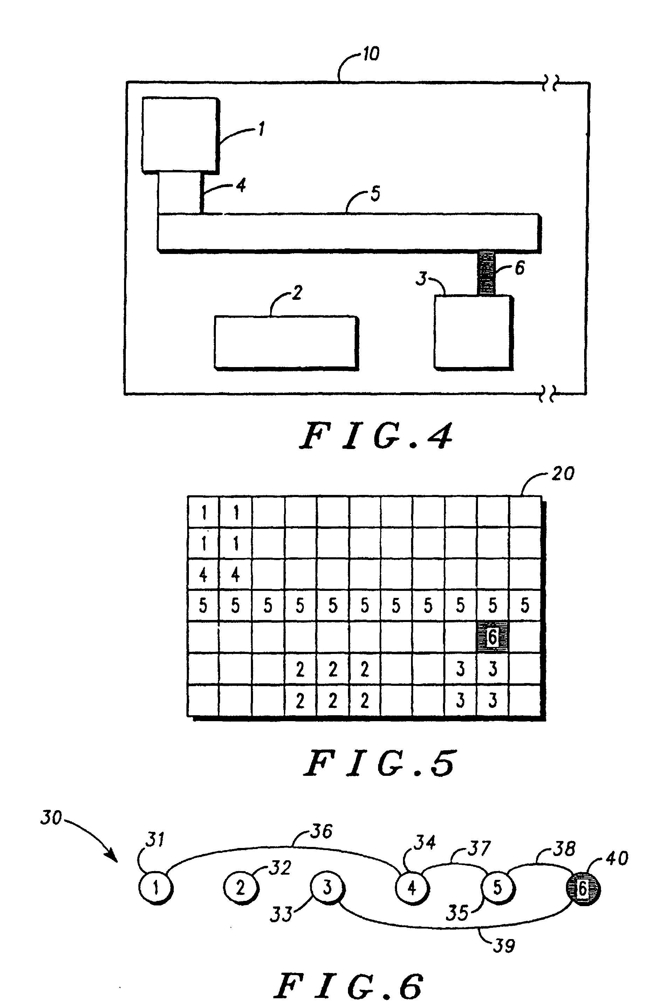

The data structure which comprises the connection graph 30 and the virtual grid 20 captures all relevant information from the layout of the electronic device 10 for purposes of the routing. In practice this data structure comprising the connection graph and the virtual grid is stored on some storage medium under program control. The routing program which implements the underlying routing algorithm can easily access the relevant information required for the routing from the data structure. Also if a new layout element is to be added - for example an additional layout element to complete the interconnection between pin 1 and pin 3 - this is also easily and efficiently reflected in the layout system by updating the data structure. This will be explained in more detail with reference to the FIG 4 to 6.

FIG. 4 is the same as FIG. 1 except that an additional layout element has been added to the layout of the electronic device 10. This additional layout element is layout element 6. Layout element 6 contacts both layout element 5 and pin 3 so that the route comprising the layout elements 4 and 5 between the pins 1 and 3 is completed. The additional layout element 6 has been found automatically by means of any known routing algorithm based on the information captured in the data structure.

In FIG. 5 it is shown how this is reflected in the virtual grid 20. Again, FIG. 5 is the same as FIG. 2 except that the virtual grid 20 is updated due to the additional layout element 6 which is added in the layout of the electronic device 10. The addition of the layout element 6 requires to index the corresponding cell or cells in the virtual grid 20 correspondingly. The area in the layout which is covered by the layout element 6 is represented by one of the cells within the grid 20. This cell is assigned the index "6" which is the index of the layout element 6. This addition is also reflected in the graph 30 shown in FIG. 6. As compared to FIG. 3 the graph 30 is expanded to contain an additional node 40. Node 40 represents the layout element 6 in the connection graph 30. Therefore it has assigned the index "6" of this layout element. Further edges 38 and 39 between the nodes 5, 6 and 6, 3 are added respectively in order to represent the fact that the layout element 5 and 6 as well as the layout element 6 and the pin 3 are contacting.

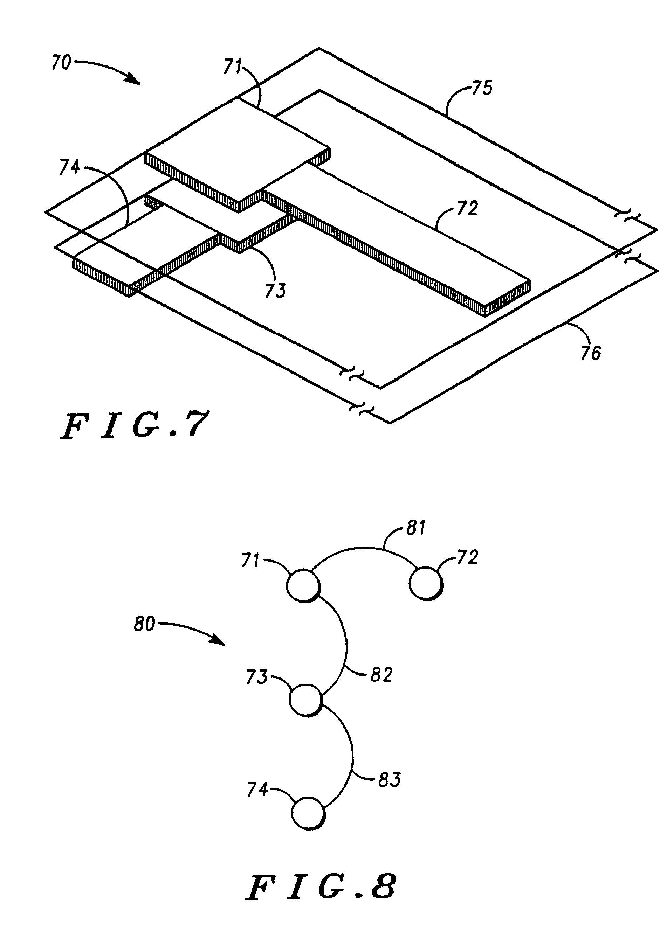

Since the route between the pins 1 and 3 is completed the routing program can complete other routing tasks relying on the same data structure which is updated permanently in order to reflect ongoing changes in the layout plan. Once the layout is finalized a mask set can be produced based on the routing which is found and the electronic device 10 is fabricated by any known semiconductor manufacturing process such as CVD or etching. With respect to FIG. 7 and 8 in the following one embodiment of the invention for a two layer layout environment is described in the following.

FIG. 7 shows a small portion of a layout area 70 of an electronic device. The fabrication process for the device which is employed allows to fabricate at least two overlaying layers 75 and 76 of circuitry. Interconnections between layout elements which are situated on different ones of the layers 75 and 76 are made possible by means of so called vias which penetrate the substrate that spaces the layers 75 and 76 apart. For simplicity the substrate is not shown in FIG. 7. On the top layer 75 the layout elements 71 and 72 are present as well as a large number of other layout elements which are not shown in the drawing for simplicity. The layout element 71 is the top portion of a via whereas the layout element 72 is a routing layout element which forms part of a route interconnecting the layout element 71 to terminals of nets which are implemented on the first layer 75.

Likewise on the layer 76 a large number of layout elements is present of which only the layout elements 73 and 74 are shown. Layout element 73 is the bottom portion of the same via and layout element 74 is a corresponding layout element.

For the purposes of a multi layer environment of the type shown in FIG. 7 an embodiment of the data structure of the invention needs to contain a separate virtual grid for each of the layers. All the layout elements which are situated on the same layer are represented by the indication of the corresponding cells in the virtual grid belonging to that layer. This is analogous to the two dimensional case considered with respect to FIG. 1 to 6. For simplicity the two virtual grids which are required for the data structure describing the layout of the device shown in FIG. 7 are not shown in the drawing. The virtual grid of the layer 75 captures the layout information of the layout elements on the layer 75 like it is the case for the virtual grid 20 of FIG. 2 with respect to the layout of the electronic device 10 of FIG. 1. The same applies analogously to the virtual grid required for the layer 76.

FIG. 8 shows connection graph 80 belonging to the layout 70 of FIG. 7. Again each of the layout elements is represented by a dedicated node in the connection graph 80 and contacts between layout elements are represented by edges between the corresponding nodes of the connection graph. As a consequence the connection graph 80 comprises nodes having the indices 71, 72, 73 and 74 and which are interconnected by the edges 81, 82 and 83, respectively. The edge 82 between the nodes being indexed 71 and 73 represents the interconnection which is established between the layers 75 and 76 by the via which has the top portion 71 and the bottom portion 73. Again the resulting data structure comprising a virtual grid for each layer and one connection graph capturing all the connection information on different layers is a very efficient basis to carry out any kind of routing.

Typically, a router performs the following actions on the data structure of the invention:
- the router tests a grid cell to determine whether it is occupied by some layout element belonging to a net or other kind of obstacle, or free. If there is no index assigned to a particular cell this means that the cell is free or busy otherwise.
- the router tests two neighboring grid cells to determine whether the cells belong to the same layout element or not. If both cells have an assigned index and these indices are equal, the cells belong to the same layout element.
- The router retrieves attribute data which are stored for a particular layout element by cell node reference, i.e. by an index assigned to a cell node: It is possible to use the index of a node in the connection graph as a pointer to a file or memory data comprising attribute information for that corresponding layout element. Such attribute information can be descriptive of physical or layout characteristics of the layout element, required conductivity, voltage or power characteristics.
- During the process of routing it is sometimes necessary to reroute a route which has been routed before and to discard the corresponding layout elements from the data structure. This is done by deleting the corresponding node and the connection graph and by erasing the indices assigned to the corresponding grid cells in the virtual grid. This requires that in the connection graph the edges which represent contacts which no longer exist are also erased.

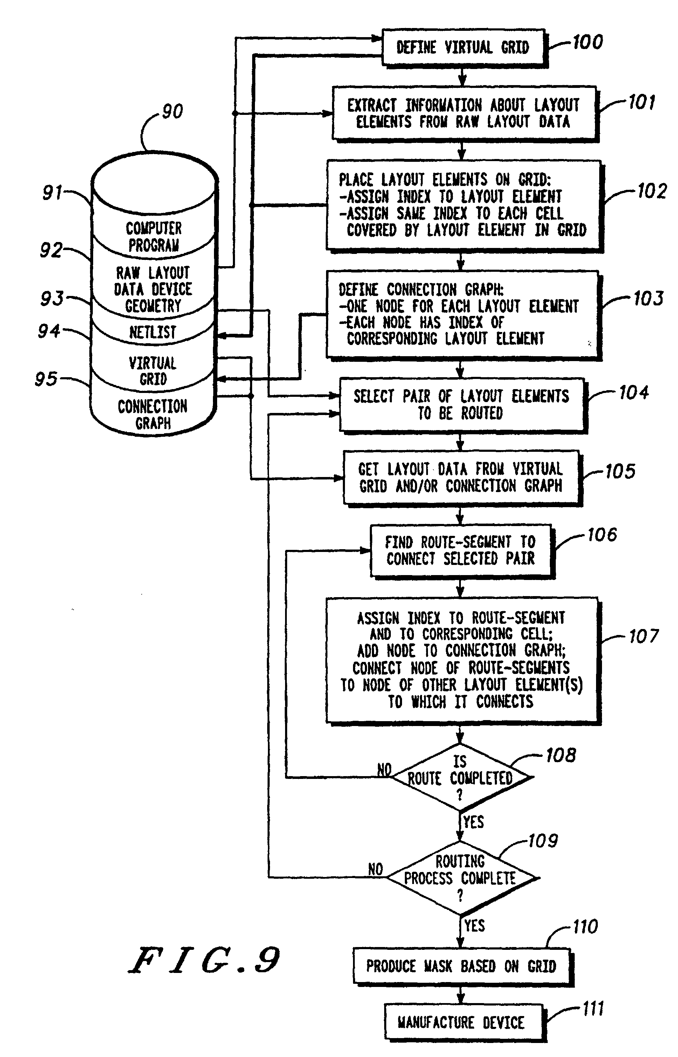

The invention is also advantageously used to produce an electronic device based on a layout which has been designed in accordance with the principals of the invention. One embodiment of a method for manufacturing an electronic device according to the invention is explained in greater detail in the following with reference to FIG. 9.

FIG. 9 shows a storage device 90 which belongs to a computer system. The address space of the storage device 90 is separated into the storage spaces 91, 92, 93, 94 and 95.

In the storage space 91 a computer program is stored which incorporates the routing system as well as the control of access operations to the storage device 90. Initially the computer program stored in storage space 91 is loaded into the computer for carrying out the routing process.

The storage space 92 serves to store raw layout data which is indicative of the overall geometry of the device to be fabricated as well as pre-defined pin positions or other constrains of relevance for the layout process.

The storage space 93 contains a net list of the nets to be wired in the electronic device. Storage space 94 serves to store one or more virtual grids depending on the number of layout layers to be manufactured. The storage space 95 serves to store the corresponding connection graph. Hence the storage spaces 94 and 95 serve for the storage of a data structure according to the invention which captures the relevant layout and connection information for the routing process.

In step 100 of the method for manufacturing an electronic device considered with respect to FIG. 9 a virtual grid is defined by the computer program. If there is more than one layer of layout to be fabricated an additional virtual grid is defined for each additional layer. This is accomplished by accessing the raw layout data from the storage space 92. Also any initial predefined positions of layout elements are accessed from the storage space 92 in step 101. These predefined layout elements are placed on the virtual grid in step 102. Like in the examples considered with respect of FIG. 1 to 8 again an unambiguous index is assigned to each layout element and the same index is assigned to each cell of the virtual grid which covers the corresponding layout element. This information is stored in the virtual grid data structure in the storage space 94 of the storage device 90.

In step 103 a connection graph is defined and stored in the storage space 95 of the storage device 90. To initiate the connection graph one dedicated node for each layout element is defined and to each node the corresponding index of the layout element which is represented by the node is assigned. In the next step 104 the net list stored in storage space 93 is accessed in order to select a pair of layout elements to be routed. In step 105 the data structure of the invention stored in the storage spaces 94 and 95 is accessed in order to get the data required for the routing algorithm.

In step 106 a first route layout element is found for the connection of the selected pair of layout elements. In step 107 an index is assigned to this layout element and to the corresponding cell of the virtual grid to reflect the addition of the layout element to the layout of the electronic device. Likewise a node is also added to the connection graph to represent the additional layout element in the connection graph. The additional node is connected by additional edges to any other node which represents a layout element which contacts the additional route layout element found in step 106 by the routing algorithm.

In step 108 it is decided whether the route to connect the selected pair of layout elements is already completed. If the decision is "no" the control returns back to step 106 to find a further route layout element for the completion of the required route. If the decision is "yes" step 109 is carried out in which the decision is taken whether the overall routing process is complete or not. The routing process is only completed when all the required interconnections as defined by the net list are already routed.

If the decision taken in step 109 is "no" the control returns back to step 104 where the next pair of layout elements to be routed is selected based on the net list. For this new pair of layout elements the sequence of steps 104 to 109 is carried out again. Eventually this results in the completion of the routing task. In this case the step 110 is carried out in which one or more masks are fabricated based on the layout information contained in the virtual grid or the virtual grids, respectively. The masks produced according to the virtual grid or grids are used to manufacture the electronic device in step 111 according to any know semiconductor device manufacturing process, such as chemical vapor deposition.

## Claims

1. A method for storing of layout data of a layout of an electronic device, said layout comprising a number of layout elements, said method comprising the steps of:
a) storing a virtual grid having a number of cells, said virtual grid spanning a layout area of said electronic device;
b) for each of said layout elements:
b1) assigning an unambiguous index to said layout element;
b2) assigning said index of said layout element to each of said cells which cover said layout element;
c) storing a connection graph, said connection graph comprising a node for each of said layout elements and an edge between two of said nodes for each pair of contacting layout elements,
d) for each of said nodes:
d1) assigning said index of said layout element of which said node is representative to said node.

2. The method for storing of layout data according to claim 1, wherein in said step of storing a virtual grid a separate virtual grid is stored for each layout layer of said electronic device.

3. The method for storing of layout data according to claim 2, wherein said connection graph comprises nodes for said layout elements on all of said layout layers of said electronic device.

4. The method for storing of layout data according to claim 1, said method further comprising a step d2) of storing of attribute data for each of said nodes.

5. The method for storing of layout data according to claim 4, said attribute data being indicative of a type of its corresponding layout element.

6. A method for routing an electrical connection in an electronic device, a layout of said electronic device being represented by layout data, said layout comprising a number of layout elements, said layout data being stored in accordance with the method according to claim 1, whereas said method for routing being **characterized by** the steps of:
e) determining a pair of said layout elements which are to be interconnected;
f) tracing an additional layout element in said virtual grid by accessing the information contained in said virtual grid and said connection graph;
g) updating said virtual grid with respect to said additional layout element by assigning a further unambiguous index to said additional layout element and assigning said index of said additional layout element to each of said cells which cover said additional layout element;
h) updating said connection graph with respect to said additional layout element by creating a further node for said additional layout element and a further edge if said additional layout element is connected to another one of said layout elements; and
i) repeating said steps e) to h) until said pair of layout elements is interconnected.

7. A method for manufacturing an electronic device having a layout, said electronic device having a number of layout elements some of which are connected by nets, said method comprising the steps of:
designing said electronic device by routing said nets;
said step of designing comprising the steps of representing said layout of said electronic device by layout data, said layout data being stored in accordance with the method according to claim 1, whereas said step of designing further comprising a step of routing said nets, said step of routing comprising the steps of:
e) determining a pair of said layout elements which are to be interconnected;
f) tracing an additional layout element in said virtual grid by accessing the information contained in said virtual grid and said connection graph;
g) updating said virtual grid with respect to said additional layout element by assigning a further unambiguous index to said additional layout element and assigning said index of said additional layout element to each of said cells which cover said additional layout element;
h) updating said connection graph with respect to said additional layout element by creating a further node for said additional layout element and a further edge if said additional layout element is connected to another one of said layout elements; and
i) repeating said steps e) to h) until said pair of layout elements are interconnected;
said method for manufacturing an electronic device further comprising a manufacturing step to implement said nets in said electronic device.

8. A program storage device embodying a program executable by a computer to perform a method for storing of layout data according to any of claims 1 - 5.

## Patentansprüche

1. Verfahren zum Speichern von Layout-Daten eines Layouts eines elektronischen Geräts, wobei das Layout eine Anzahl von Layout-Elementen umfasst, wobei das Verfahren die Schritte umfasst:
a) Speichern eines virtuellen Gitters mit einer Anzahl von Zellen, wobei das virtuelle Gitter einen Layout-Bereich des elektronischen Gerätes aufspannt;
b) für jedes der Layout-Elemente:
b1) Zuordnen eines unzweideutigen Indexes zu dem Layout-Element;
b2) Zuordnen des Indexes des Layout-Elementes zu jeder derjenigen Zellen, die das Layoutelement abdecken;
c) Speichern eines Verbindungsgraphen, wobei der Verbindungsgraph einen Knoten für jedes der Layout-Elemente umfasst sowie eine Kante zwischen zwei der Knoten für jedes Paar von einander kontaktierenden Layout-Elementen;
d) Für jeden der Knoten:
d1) Zuordnen des Indexes des Layout-Elements; welches der Knoten repräsentiert, zu diesem Knoten.

2. Verfahren zum Speichern von Layout-Daten nach Anspruch 1, wobei in dem Schritt des Speicherns eines virtuellen Gitters ein separates virtuelles Gitter für jede Layout-Ebene des elektronisches Gerätes gespeichert wird.

3. Verfahren zum Speichern von Layout-Daten nach Anspruch 2, wobei der Verbindungsgraph Knoten für die Layout-Elemente auf allen Layout-Ebenen des elektronischen Gerätes umfasst.

4. Verfahren zum Speichern von Layout-Daten nach Anspruch 1, wobei das Verfahren einen weiteren Schritt d2 zum Speichern von Eigenschaftsdaten für jeden der Knoten umfasst.

5. Verfahren zum Speichern von Layout-Daten nach Anspruch 4, wobei die Eigenschaftsdaten einen Typ des ihnen entsprechenden Layout-Elementes anzeigen.

6. Routingverfahren für eine elektrische Verbindung in einem elektronischen Gerät, wobei ein Layout des elektronischen Gerätes durch Layout-Daten repräsentiert wird, wobei das Layout eine Anzahl von Layout-Elementen umfasst, wobei die Layout-Daten gemäß dem Verfahren nach Anspruch 1 gespeichert werden, wobei das Routingverfahren **gekennzeichnet ist durch** die Schritte:
e) Bestimmen eines Paares der Layout-Elemente, die miteinander verbunden werden sollen;
f) Ausfindigmachen eines zusätzlichen Layout-Elementes in dem virtuellen Gitter **durch** Zugriff auf die Information, die in dem virtuellen Gitter und dem Verbindungsgraph enthalten ist;
g) Aktualisieren des virtuellen Gitters in Bezug auf das zusätzliche Layout-Element **durch** Zuordnung eines weiteren unzweideutigen Indexes zu dem zusätzlichen Layout-Element und Zuordnen des Indexes des zusätzlichen Layout-Elementes zu jeder der Zellen, die das zusätzliche Layout-Element abdecken;
h) Aktualisieren des Verbindungsgraphen in Bezug auf das zusätzliche Layout-Element **durch** Erstellung eines weiteren Knotens für das zusätzliche Layout-Element und einer weiteren Kante, falls das zusätzliche Layout-Element mit einem der anderen Layout-Elemente verbunden ist; und
i) Wiederholen der Schritte e) bis h) bis das Paar von Layout-Elementen verbunden ist.

7. Verfahren zur Herstellung eines elektronischen Gerätes, das ein Layout aufweist, wobei das elektronische Gerät eine Anzahl von Layout-Elementen umfasst, von denen einige durch Netzwerke verbunden sind, wobei das Verfahren die Schritte umfasst:
Entwerfen des elektronischen Gerätes durch Routing der Netzwerke;
wobei der Schritt des Entwerfens die Schritte des Repräsentierens des Layouts des elektronischen Gerätes durch Layout-Daten, die gemäß dem Verfahren nach Anspruch 1 gespeichert werden, umfasst, wobei der Schritt des Entwerfens weiter einen Schritt des Routings der Netzwerke umfasst, wobei der Schritt des Routings die Schritte umfasst:
e) Bestimmen eines Paares der Layout-Elemente, die miteinander verbunden werden sollen;
f) Ausfindigmachen eines zusätzlichen Layout-Elementes in dem virtuellen Gitter durch Zugriff auf die Information, die in dem virtuellen Gitter und dem Verbindungsgraph enthalten ist;
g) Aktualisieren des virtuellen Gitters in Bezug auf das zusätzliche Layout-Element durch Zuordnen eines weiteren unzweideutigen Indexes zu dem zusätzlichen Layout-Element und Zuordnen des Indexes des zusätzlichen Layout-Elementes zu jeder der Zellen, die das zusätzliche Layout-Element abdecken;
h) Aktualisieren des Verbindungsgraphen in Bezug auf das zusätzliche Layout-Element durch Erstellung eines weiteren Knotens für das zusätzliche Layout-Element und einer weiteren Kante, falls das zusätzliche Layout-Element mit einem der anderen Layout-Elemente verbunden ist; und
i) Wiederholen der Schritte e) bis h) bis das Paar von Layout-Elementen miteinander verbunden ist;
wobei das Verfahren zur Herstellung eines elektronischen Gerätes weiter einen Fertigungsschritt zur Implementierung der Netzwerke in dem elektronische Gerät umfasst.

8. Programmspeichervorrichtung, enthaltend ein auf einem Computer ausführbares Programm zur Durchführung eines Verfahrens zum Speichern von Layout-Daten gemäß einem der Ansprüche 1 bis 5.

## Revendications

1. Procédé de mémorisation des données de dessin du dessin d'un dispositif électronique, ledit dessin comprenant un certain nombre d'éléments de dessin, ledit procédé comprenant les étapes qui consistent à :
a) mémoriser une grille virtuelle ayant un certain nombre de cellules, ladite grille virtuelle recouvrant une zone de dessin dudit dispositif électronique ;
b) pour chacun desdits éléments de dessin :
b1) attribuer un index non ambigu audit élément de dessin ;
b2) attribuer ledit index dudit élément de dessin à chacune desdites cellules qui recouvrent ledit élément de dessin ;
c) mémoriser un graphe de connexion, ledit graphe de connexion comprenant un noeud pour chacun desdits éléments de dessin, et un arc entre deux desdits noeuds, pour chaque paire d'éléments de dessin en contact l'un avec l'autre ;
d) pour chacun desdits noeuds,
d1) attribuer audit noeud ledit index dudit élément de dessin dont ledit noeud est représentatif.

2. Procédé de mémorisation de données de dessin selon la revendication 1, dans lequel, dans ladite étape de mémorisation d'une grille virtuelle, une grille virtuelle distincte est mémorisée pour chaque couche de dessin dudit dispositif électronique.

3. Procédé de mémorisation de données de dessin selon la revendication 2, dans lequel ledit graphe de connexion comprend des noeuds pour lesdits éléments de dessin, sur la totalité desdites couches de dessin dudit dispositif électronique.

4. Procédé de mémorisation de données de dessin selon la revendication 1, ledit procédé comprenant, en outre, l'étape d2) consistant à mémoriser des données d'attributs pour chacun desdits noeuds.

5. Procédé de mémorisation de données de dessin selon la revendication 4, lesdites données d'attribut étant représentatives du type de l'élément de dessin qui leur correspond.

6. Procédé de routage d'une connexion électrique dans un dispositif électronique, le dessin dudit dispositif électronique étant représenté par des données de dessin, ledit dessin comprenant un certain nombre d'éléments de dessin, lesdites données de dessin étant mémorisées en conformité avec le procédé selon la revendication 1, ledit procédé de routage étant **caractérisé par** les étapes qui consistent à :
e) déterminer deux desdits éléments de dessins qui doivent être interconnectés ;
f) tracer un élément de dessin additionnel dans ladite grille virtuelle, en accédant aux informations contenues dans ladite grille virtuelle et ledit graphe de connexion ;
g) mettre à jour ladite grille virtuelle en ce qui concerne ledit élément de dessin additionnel, en attribuant un autre index non ambigu audit élément de dessin additionnel et en attribuant ledit index dudit élément de dessin additionnel à chacune desdites cellules qui recouvrent ledit élément de dessin additionnel ;
h) mettre à jour ledit graphe de connexion en ce qui concerne ledit élément de dessin additionnel, en créant un autre noeud pour ledit élément de dessin additionnel et un autre arc si ledit élément de dessin additionnel est connecté à un autre desdits éléments de dessin ; et
i) répéter lesdites étapes e) à h) jusqu'à ce que lesdits deux éléments de dessin soient interconnectés.

7. Procédé de fabrication d'un dispositif électronique ayant un dessin, ledit dispositif électronique ayant un certain nombre d'éléments de dessin, dont certains d'entre eux sont connectés par des équipotentielles, ledit procédé comprenant les étapes qui consistent à :
concevoir ledit dispositif électronique en routant lesdites équipotentielles ;
ladite étape de conception comprenant les étapes qui consistent à représenter ledit dessin dudit dispositif électronique par des données de dessin, lesdites données de dessin étant mémorisées en conformité avec le procédé selon la revendication 1, ladite étape de conception comprenant, en outre, les étapes qui consistent à :
e) déterminer deux desdits éléments de dessins qui doivent être interconnectés ;
f) tracer un élément de dessin additionnel dans ladite grille virtuelle, en accédant aux informations contenues dans ladite grille virtuelle et ledit graphe de connexion ;
g) mettre à jour ladite grille virtuelle en ce qui concerne ledit élément de dessin additionnel, en attribuant un autre index non ambigu audit élément de dessin additionnel et en attribuant ledit index dudit élément de dessin additionnel à chacune desdites cellules qui recouvrent ledit élément de dessin additionnel ;
h) mettre à jour ledit graphe de connexion en ce qui concerne ledit élément de dessin additionnel, en créant un autre noeud pour ledit élément de dessin additionnel et un autre arc si ledit élément de dessin additionnel est connecté à un autre desdits éléments de dessin ; et
i) répéter lesdites étapes e) à h) jusqu'à ce que lesdits deux éléments de dessin soient interconnectés ;
ledit procédé de fabrication d'un dispositif électronique comprenant, en outre, une étape de fabrication pour implanter lesdites équipotentielles dans ledit dispositif électronique.

8. Dispositif de mémorisation de programme utilisant un programme exécutable par un ordinateur, pour mettre en oeuvre un procédé de mémorisation de données de dessin selon l'une quelconque des revendications 1 à 5.
